# EUROPÄISCHE PATENTSCHRIFT

(11) **EP 1 880 227 B1**
(45) Veröffentlichungstag und Bekanntmachung des Hinweises auf die Patenterteilung: **12.01.2011**
(21) Anmeldenummer: 06722683.7
(22) Anmeldetag: 25.03.2006
(51) Int. Cl.: G01R 33/28

(54) **HYPERPOLARISATION VON LI UND WEITEREN KERNEN**
HYPERPOLARIZATION OF LITHIUM AND OTHER NUCLEI
HYPERPOLARISATION DU LITHIUM ET D'AUTRES NOYAUX

(30) Priorität: 18.04.2005 DE 102005017927
(43) Veröffentlichungstag der Anmeldung: 23.01.2008
(73) Patentinhaber: Forschungszentrum Jülich GmbH, 52425 Jülich (DE)
(72) Erfinder: APPELT, Stephan, 52070 Aachen (DE); HÄSING, Wolfgang, 52428 Jülich (DE); SIELING, Ulrich, 41812 Erkelenz (DE); KÜHN, Holger, 51373 Leverkusen (DE)
(86) Internationale Anmeldenummer: PCT/DE2006/000531
(87) Internationale Veröffentlichungsnummer: WO 2006/111126

(56) Entgegenhaltungen:
- WO-A2-99/08766
- NEUGART R: "Spin exchange polarization and measurement of the hyperfine splitting of short-lived <8>Li" ZEITSCHRIFT FUR PHYSIK A (ATOMS AND NUCLEI) WEST GERMANY, Bd. 261, 1973, Seiten 237-248, XP008069814 ISSN: 0340-2193
- ANDERSON L W: "Preparation methods and depolarization processes in internal polarized targets of Li or Na" AIP CONFERENCE PROCEEDINGS USA, Bd. 2, 1989, Seiten 1545-1551, XP008069828 ISSN: 0094-243X
- BALLING L C ET AL: "Optical pumping at high temperatures" PHYSICAL REVIEW LETTERS USA, Bd. 22, 3. Februar 1969 (1969-02-03), Seiten 161-163, XP002403253 ISSN: 0031-9007

## Beschreibung

Die Erfindung betrifft die Hyperpolarisation von Lithium sowie weiterer Kernspins, die durch lange longitudinalen T₁-Relaxati-onszeiten charakterisiert sind, z. B. ¹³C, ²⁹Si, ³¹P.

Neuere Entwicklungen in der Magnet Resonanz Tomographie (MRT) sowie in der Magnet Resonanz Spektroskopie (NMR) mit polarisierten Edelgasen haben viele Anwendungen in der Medizin, in der Physik und in den Materialwissenschaften geschaffen. Die Polarisation von Edelgaskernen kann durch optisches Pumpen mit Hilfe von Alkalimetallatomen erzielt werden, wie der Druckschrift Happer et al., Phys. Rev. A, 29, 3092 (1984) zu entnehmen ist.

Der Begriff des optischen Pumpens umfasst das von Kastler entwickelte Verfahren, durch Lichteinstrahlung in Materie die Besetzungszahlen bestimmter Energiezustände gegenüber dem Gleichgewichtszustand bedeutend zu erhöhen. Durch optisches Pumpen können die relativen Besetzungszahlen von Energieniveaus in Atomen, Ionen, Molekülen und Festkörpern verändert und Ordnungszustände hervorgerufen werden. Die Besetzungsdichte des optisch gepumpten Zustandes weicht deutlich von seiner thermischen Besetzungswahrscheinlichkeit gemäß der Boltzmann-Verteilung ab. Durch optisches Pumpen von Zeeman-Niveaus kann z. B. eine Parallelstellung der magnetischen Momente der Elektronen bzw. der Kerne von Atomen erreicht werden.

Typischerweise wird in der Praxis das Alkalimetallatom Rubidium in Anwesenheit der Edelgase Helium und Stickstoff eingesetzt. Es ist bekannt, damit eine Kernspinpolarisation von z. B. ¹²⁹Xe von etwa 20 Prozent zu erreichen. Eine solche Kernspinpolarisation ist ca. 100000 mal größer als die Gleichgewichtspolarisation in klinischen Magnet Resonanz Tomographen bei 1 T und 300 K. Die damit verbundene drastische Steigerung des Signal-Rausch-Verhältnisses erklärt, weshalb in Zukunft neue Anwendungsmöglichkeiten in der Medizin, Wissenschaft und Technik erwartet werden.

Unter Polarisation wird der Grad der Ausrichtung (Ordnung) der Spins von Atomkernen, Elektronen oder Photonen verstanden. Zum Beispiel bedeutet 100 Prozent Polarisation, dass sämtliche Kerne oder Elektronen in gleicher Weise orientiert sind. Mit der Polarisation von Kernen oder Elektronen ist ein magnetisches Moment verbunden.

Als Hyperpolarisation bezeichnet man einen Polarisationsgrad von Kern- oder Elektronenspins, der größer ist, als der thermische Polarisationsgrad der Spins in einem gegebenen Magnetfeld bei Raumtemperatur.

Hyperpolarisierte Edelgase werden als Kontrastmittel oder zur NMR-Spektroskopie eingesetzt. Hyperpolarisiertes ¹²⁹Xe wird zum Beispiel von einem Menschen inhaliert oder in ihn injiziert. 10 bis 15 Sekunden später sammelt sich das polarisierte Xenon im Gehirn an. Mit Hilfe der Magnetischen Resonanz Tomographie wird die Verteilung des Edelgases im Gehirn festgestellt. Das Ergebnis wird für weitere Analysen genutzt.

Die Wahl des Edelgases hängt jeweils vom Anwendungsfall ab. ¹²⁹Xe weist eine große chemische Verschiebung auf. Wird Xenon z. B. auf einer Oberfläche adsorbiert, so verändert sich signifikant seine Resonanzfrequenz. Außerdem löst sich Xenon in lipophilen Flüssigkeiten. Wenn derartige Eigenschaften erwünscht sind, wird Xenon eingesetzt.

Das Edelgas Helium löst sich kaum in Flüssigkeiten. Das Isotop ³He wird daher regelmäßig dann verwendet, wenn Hohlräume betroffen sind. Die Lunge eines Menschen stellt ein Beispiel für einen solchen Hohlraum dar.

Einige Edelgase weisen andere wertvolle Eigenschaften als die vorgenannten auf. So besitzen z. B. die Isotope ⁸³Kr, ²¹Ne und ¹³¹Xe ein Quadrupolmoment, welches z. B. für Experimente in der Grundlagenforschung bzw. in der Oberflächenphysik interessant ist. Diese Edelgase sind allerdings sehr teuer, so dass diese für Anwendungen, bei denen größere Mengen verwendet werden, ungeeignet sind.

Aus der Druckschrift Driehuys et al. (Appl. Phys. Lett. (1996). 69, 1668) ist bekannt, Edelgase auf folgende Weise in einem Polarisator zu polarisieren.

Ausgehend von einer Gasversorgung wird ein Gasstrom, bestehend aus einem Gemisch von ¹²⁹Xe, ⁴He und N₂, in einem Rb-Behälter mit Rb-Dampf angereichert und durch eine Pumpzelle geleitet. Mit Hilfe eines Lasers wird zirkular polarisiertes Licht bereitgestellt, also Licht, bei dem der Drehimpuls bzw. der Spin der Photonen alle in die gleiche Richtung zeigen. In der Pumpzelle werden die Rb-Atome als pumpbare Spezies mit dem Laserstrahl (λ~ 795 nm, Rb D1-Linie) longitudinal zu einem Magnetfeld optisch gepumpt und so die Elektronenspins der Rb-Atome polarisiert. Dabei wird der Drehimpuls der Photonen auf freie Elektronen von Alkalimetallatomen übertragen. Die Spins der Elektronen der Alkalimetallatome weisen somit eine große Abweichung vom thermischen Gleichgewicht auf. Die Alkalimetallatome sind folglich polarisiert. Durch einen Stoß eines Alkalimetallatoms mit einem Edelgasatom wird die Polarisation des Elektronenspins vom Alkalimetallatom auf das Edelgasatom übertragen. Es entsteht so kernspinpolarisiertes Edelgas. Die durch das optische Pumpen von Alikaliatomen erzeugte Polarisation des Elektronenspins der Alkalimetallatome wird also durch Spinaustausch vom Alkali-Elektron auf den Kernspin der Edelgase übertragen, wie erstmals von Bouchiat am Rb/³He-System gezeigt wurde.

Aus WO 99/08766 ist bekannt, neben einem ersten optisch pumpbaren Alkalimetall ein Hilfs-Alkalimetall als zweite polarisierbare Spezies einzusetzen. Die optisch gepumpte Alkalimetall-Spezies überträgt dabei die Elektronenspinpolarisation auf die Hilfs-Alkalimetall-Spezies, wodurch effektiver und schneller die Alkalipolarisation auf die Edelgaskerne, z. B. für ³He, übertragen wird.

Alkalimetallatome werden eingesetzt, da diese über ein großes optisches Dipolmoment verfügen, welches mit dem Licht wechselwirkt. Ferner weisen Alkalimetallatome jeweils ein freies Elektron auf, so dass keine nachteiligen Wechselwirkungen zwischen zwei und mehr Elektronen pro Atom auftreten können.

Cäsium wäre ebenfalls ein gut geeignetes Alkalimetallatom, welches gegenüber Rubidium zur Erzielung vorgenannter Wirkungen überlegen ist. Laser mit der passenden optischen Cs-Wellenlänge und mit genügend hoher Leistung, wie sie für die Polarisation von Xenon mittels Cäsium benötigt würden, sind aber auf dem Markt wenig verbreitet, verglichen mit den entsprechenden Lasern für Rb.

Um bei der Verwendung breitbandiger Hochleistungs-Halbleiter-laser möglichst viele Photonen nutzen zu können, wird beim optischen Pumpen von Edelgasen bei Drücken von mehreren Atmosphären gearbeitet. Dabei unterscheidet sich das optische Pumpen von Alkalimetall-Atomen je nach Art des zu polarisierenden Edelgases.

Zur Polarisation von ¹²⁹Xe wird ein Gasgemisch unter einem Druck von etwa 7000bis 10000h Per durch eine zylindrische Glaszelle kontinuierlich oder halbkontinuierlich durchgeleitet. Das Gasgemisch besteht zu 94 Prozent aus ⁴He, zu 5 % aus Stickstoff und zu 1 % aus Xenon. Die typische Fließgeschwindigkeit des Gasgemisches beträgt 1 cm je Sekunde.

Hyperpolarisierte Kern- und Elektronenspins relaxieren in Abhängigkeit von ihrer Umgebung mehr oder weniger schnell. Man unterscheidet zwischen longitudinaler T₁-Relaxationszeit (kurz: T₁-Zeit), der so genannten Spin-Gitter-Relaxation benachbarter Spins, und der transversalen T₂-Relaxationszeit, der so genannten Spin-Spin-Relaxation.

Im Falle der Polarisation von ³He wird der nötige Druck im Polarisator durch das ³He selbst erzeugt, da die Elektronenspinrelaxationsrate von Rb-³He-Stößen klein ist. Beim Spinaustauschpumpen von Rb-¹²⁹Xe ist dies nicht der Fall, weshalb der Druck durch ein zusätzliches Puffergas wie ⁴He erzeugt wird. Aus den unterschiedlichen Relaxations- und Spinaustauschraten ergeben sich unterschiedliche Anforderungen an die Polarisatoren.

So liegen bei ³He die Kernspin-Polarisations-Aufbauzeiten im Bereich von Stunden. Da aber auch die Rubidium-Spin-Zerstörungsrate für Rubidium-³He-Stöße relativ gering ist, kann hier bei hohen ³He-Drücken gearbeitet werden 5000 hPer (> 5 bar).

Für ¹²⁹Xe hingegen liegen die Kernspin-Polarisations-Aufbauzeiten aufgrund des größeren Spinaustausch-Wirkungsquerschnittes zwischen 20 bis 40 Sekunden. Aufgrund der sehr großen Rubidium Elektronenspinrelaxationsrate für Rubidium-Xenon-Stöße darf beim optischen Spinaustauschpumpen der Xenon-Partialdruck nur weniger als 100 mbar betragen, damit eine genügend hohe Rubidium-Polarisation aufrecht erhalten werden kann. Deshalb wird in solchen Polarisatoren ⁴He zur Linienverbreiterung als Puffergas eingesetzt.

Die Polarisatoren können als Fluss-Polarisatoren z. B. zur Polarisation von ¹²⁹Xe oder als Polarisatoren mit einer abgeschlossenen Probenzelle für z. B. ³He ausgestaltet sein.

In einem Durchflusspolarisator durchströmt das Gasgemisch zunächst ein Gefäß, nachfolgend "Vorratsgefäß" genannt, in dem sich eine gewisse Menge Rb befindet. Das Vorratsgefäß mit dem darin befindlichen Rubidium wird zusammen mit der sich anschließenden Glaszelle auf ca. 100 bis 170 Grad Celsius erwärmt. Durch Bereitstellung dieser Temperaturen wird das Rubidium verdampft. Die Konzentration der verdampften Rubidium-Atome in der Gasphase wird durch die Temperatur im Vorratsgefäß bestimmt. Der Gasstrom transportiert die verdampften Rubidium-Atome von dem Vorratsgefäß z. B. in eine zylindrische Probenzelle. Ein leistungsstarker, zirkular polarisiertes Licht bereitstellender Laser mit ca. 50-100 Watt Leistung im kontinuierlichen Betrieb durchstrahlt die Probenzelle axial, das heißt in Flussrichtung und pumpt optisch die Rubidium-Atome in einen hochpolarisierten Zustand. Die Wellenlänge des Lasers muss dabei auf die optische Absorptionslinie der Rubidium-Atome (D1-Linie) abgestimmt sein.
Mit anderen Worten: Um die Polarisation von Licht auf ein Alkalimetallatom optimal zu übertragen, muss die Frequenz des Lichts mit der Resonanzfrequenz des optischen Übergangs übereinstimmen.

Die Probenzelle befindet sich in einem statischen magnetischen Feld B₀ von etwa 0.0001T, das von Spulen, insbesondere einem so genannten Helmholtzspulenpaar, erzeugt wird. Die Richtung des magnetischen Feldes verläuft parallel zur Zylinderachse der Probenzelle bzw. parallel zur Strahlrichtung des Lasers. Das Magnetfeld dient der Führung der polarisierten Atome. Die durch das Licht des Lasers optisch hochpolarisierten Rubidium-Atome kollidieren in der Glaszelle unter anderem mit den Xenon-Atomen und geben ihre Polarisation an die Xenon-Atome ab.

Am Ausgang der Probenzelle scheidet sich das Rubidium aufgrund des hohen Schmelzpunkts im Vergleich zu den Schmelzpunkten der übrigen Gase an der Wand ab. Das polarisierte Xenon bzw. das Restgasgemisch wird von der Probenzelle in eine Ausfriereinheit weitergeleitet. Diese besteht aus einem Glaskolben, dessen Ende in flüssigen Stickstoff getaucht ist. Der Glaskolben befindet sich ferner in einem Magnetfeld mit einer Stärke von > 0.1T. Das hochpolarisierte Xenon-Gas scheidet sich an der inneren Glaswand der Ausfriereinheit als Eis ab.

Die Flussgeschwindigkeit in der gesamten Anordnung kann über ein Nadelventil gesteuert und mit einem Messgerät gemessen werden.

Steigt die Flussgeschwindigkeit zu sehr an, so verbleibt keine Zeit zur Übertragung der Polarisation von den Rubidium-Atomen auf die Xenon-Atome. Es wird also nur eine geringe Polarisation erzielt. Ist die Flussgeschwindigkeit zu niedrig, so verstreicht zuviel Zeit, bis die gewünschte Menge an hochpolarisiertem Xenon eingefroren ist. Durch Relaxation im Xe-Eis nimmt die Polarisation der Xenon-Atome nämlich wieder ab. Die Relaxation der Xenon-Atome wird durch das Einfrieren sowie durch ein starkes Magnetfeld, welchem die Ausfriereinheit ausgesetzt ist, stark verlangsamt. Es ist daher erforderlich, nach der Polarisierung das Edelgas Xenon möglichst schnell und verlustfrei einzufrieren. Zwar kann die Relaxation durch das Einfrieren nicht ganz vermieden werden. Es verbleiben jedoch bei 77 K ungefähr 1 bis 2 Stunden Zeit, ehe die Xenon-Polarisation so stark abgenommen hat, dass eine weitere Verwendung des anfangs hochpolarisierten Gases nicht mehr möglich ist.

Um ein einzelnes freies Alkalimetallatom zu polarisieren, ist eine bestimmte Energie erforderlich. Die erforderliche Energie entspricht der Resonanzfrequenz zur Anhebung des freien Elektrons des Alkalimetallatoms von einem Grundzustand in einen angeregten Zustand. Um die Energie von einem Laser auf das'Alkalimetallatom optimal zu übertragen, muss die Frequenz des Lichts des Lasers auf die Resonanzfrequenz des Alkalimetallatoms abgestimmt werden. Einige Laser senden ihr Licht innerhalb eines bestimmten Frequenzspektrums aus. Es handelt sich dabei also nicht um eine einzelne Frequenz, sondern um eine Verteilung von Frequenzen. Das zur Verfügung stehende Spektrum eines Lasers wird durch die sogenannte Linienbreite charakterisiert. Um wirtschaftlich Alkalimetallatome zu polarisieren, werden breitbandige Halbleiter-Laser vorgesehen, deren Frequenz und Linienbreite auf die Resonanzfrequenz bzw. die optische Linienbreite des Alkalimetallatoms abgestimmt sind.

Um die Energie von einem Laser auf Alkalimetallatome besser übertragen zu können, sind während der Polarisation Stoßpartner für die Alkalimetallatome vorgesehen. Als Stoßpartner dienen insbesondere die ⁴He-Atome. Durch die Wechselwirkung bzw. durch die Stöße mit den Helium-Atomen verbreitert sich die optische Linienbreite eines Alkalimetallatoms. Je breiter dieses atomare Spektrum ist, desto eher können spektral breite und damit preiswerte Laser eingesetzt werden.

Die Anzahl der Stöße zwischen einem Alkalimetallatom und einem Stoßpartner wie ⁴He ist umso höher, je höher der Druck ist. Für ⁴He zum Beispiel ist die Verbreiterung der optischen Linienbreite des Alkalimetallatoms proportional zum Druck des Heliumgases. Außerdem besitzt ⁴He die wertvolle Eigenschaft, dass es nur wenig zerstörenden Einfluss auf die Polarisation der Alkalimetallatome hat. Bei der Polarisation von ¹²⁹Xe wird daher regelmäßig mit einem Gasgemisch gearbeitet, welches zu 94 Prozent aus ⁴He besteht und einen Druck von etwa 10000h Per besitzt.

Bei dem gemäß Stand der Technik bekannten 100 Watt starken Laser für die Hyperpolarisation der Rb-Elektronen handelt es sich um einen glasfasergekoppelten Diodenlaser mit einer typischen Spektralbreite von 2 bis 4 Nanometern. Bei einem Gasdruck von 10 bar ist die Linienbreite des optischen Überganges von Rubidiumatomen auf ca. 0,3 Nanometer verbreitert. Daher wird in den vorhandenen Rubidium-Xenon-Polarisatoren, in denen zum optischen Pumpen Hochleistungs-Diodenlaser mit typischerweise 2 Nanometer Linienbreite eingesetzt werden, nur ein Bruchteil des Laserlichts genutzt.

Die Partialdrucke von ⁴He betragen in dem Gasgemisch bis zu 10 000hPer. Im Vergleich zu den übrigen Partialdrucken (Xenon bzw. Stickstoff) ist dies sehr hoch. Dies soll bewirken, dass polarisierte Alkalimetall- oder Edelgasatome selten an die Innenwand der Glaszelle gelangen und dort z. B. durch Wechselwirkung mit paramagnetischen Zentren ihre Polarisation verlieren.

Mit zunehmendem Partialdruck des ⁴He nimmt also die Wahrscheinlichkeit ab, dass polarisierte Atome nachteilhaft an die Zellinnenwand stoßen.

Ein polarisiertes Alkalimetallatom wie z.B. Rubidium vermag eine Fluoreszenzstrahlung zu erzeugen. Wird eine solche Strahlung von einem weiteren polarisierten Alkalimetallatom eingefangen, so führt dieser Einfang zur Depolarisation des Alkalimetallatoms. Der bei der Polarisation von Edelgasen eingesetzte Stickstoff im Gasgemisch dient der Verhinderung des Fluoreszenzlichtes und damit des Strahlungseinfangs. Das Element Stickstoff im Gasgemisch weist ebenso wie Xenon nur einen geringen Partialdruck auf. Dieser Partialdruck beträgt typischerweise ca. 100 h Per.

Die schweren Edelgas-Atome, wie z. B. Xenon-Atome, verursachen bei Stößen mit den Alkalimetallatomen eine starke Relaxation der Polarisation der Alkalimetallatome. Um die Polarisation der Alkalimetallatome beim optischen Pumpen so groß wie möglich zu halten, muss der Partialdruck des Xenongases im Gasgemisch entsprechend klein sein. Selbst bei einem Xenon-Partialdruck im Gasgemisch von 0,1 bar braucht man Laserleistungen um die 100 Watt, um im ganzen Probenvolumen eine Polarisation der Alkalimetallatome von etwa 70 Prozent zu erreichen.

Ein Gasvolumen mit geeigneter Zusammensetzung wird gemäß Stand der Technik durch eine zylinderförmige Probenzelle gedrückt. Das Licht des Lasers, der die Polarisation erzeugt, wird in der Probenzelle absorbiert. Dabei durchstrahlt der Pumpstrahl die Probenzelle in Strömungsrichtung des Gemisches, welches die optisch pumpbare Spezies und die zu hyperpolarisierenden Atomkerne umfasst, parallel zum Magnetfeld.
Aus US 2002/0107439 A1 hingegen ist bekannt, dass Laserlicht im Gegenstrom zu dem fließenden Gemisch in die Probenzelle einzustrahlen.

In biologischen Systemen schränken kurze longitudinale T₁-Zeiten der Edelgaskerne im Blut sowie die geringe Löslichkeit in wässrigen Lösungen den Einsatz hyperpolarisierter Edelgase stark ein. Beispielsweise ist es für medizinische Zwecke bisher nicht gelungen, ¹²⁹Xe mit ausreichender Polarisationsdichte in das Gehirn zu transportieren, da die T₁-Zeiten im Blut nur kurz sind (~ 10 s) und die Transporttechnologie hierfür sehr aufwendig ist, bzw. noch gar nicht entwickelt wurde. Ähnliches gilt auch für die übrigen in Diskussion befindlichen Edelgase.

In DE 102 38 637 A1 wird ein Verfahren zur Herstellung kernspinpolarisierter Flüssigkeiten vorgestellt. Hierbei wird ein polarisierter Li-Atomstrahl mittels optischen Pumpens oder mit einer Stern-Gerlach-Anordnung erzeugt und auf die Flüssigkeit geleitet.
Nachteilig sind damit aber nur Dichten von maximal 10¹³ cm⁻³ Lithiumatome im Atomstrahl erreichbar. Das Verfahren funktioniert zudem nur bei geringen Drücken <0.1Per.
Dies beschränkt die Gesamtzahl der produzierten polarisierten Li-Atome bzw. Ionen (< 10¹⁵) beträchtlich.

Für einen Einsatz von hyperpolarisiertem ⁶Li und auch ⁷Li in den Lebens- und Materialwissenschaften ist die Produktion und Speicherung von größeren Mengen von etwa 10¹⁹ hyperpolarisierter Li⁺-Ionen oder Li-Atomen wünschenswert.

Aufgabe der Erfindung ist es, ein Verfahren zur Hyperpolarisation von Lithium bereit zu stellen, welches zu einer viel höheren Dichte bzw. Gesamtzahl polarisierter Lithiumatome bzw. - Ionen führt.

Darüber hinaus ist es eine weitere Aufgabe der Erfindung, ein allgemeines Verfahren zur Herstellung größerer Mengen hyperpolarisierter Substanzen in festem oder flüssigem Zustand zu erzeugen.

Die Aufgabe wird durch die Verfahren mit der Gesamtheit der Merkmale des Anspruchs 1 sowie der Nebenansprüche gelöst. Vorteilhafte Ausgestaltungen ergeben sich aus den darauf rückbezogenen Ansprüchen.

Das erfindungsgemäße Verfahren zur Hyperpolarisation von Lithiumatomen in einem Gemisch durch optisches Pumpen in einer Probenzelle, ist gekennzeichnet durch optisches Pumpen einer ersten Alkalimetallsorte mittels Laserlicht. Sodann wird Spinaustausch vom optisch gepumpten Elektron der ersten Alkalimetallsorte auf das Elektron des Lithiumatoms im Grundzustand herbeigeführt.

Wie nachfolgend erläutert wird, können auf diese Weise die aus dem Stand der Technik bekannten, und wie oben gezeigt, mit erheblichen Nachteilen behafteten, hyperpolarisierten Edelgase als Kontrastmittel ersetzt werden.

Wie Tab. 1 zu entnehmen ist, können zwar eine Reihe von Alkalimetallen in ihrer Dampfphase mit unterschiedlichen Schwierigkeitsgraden optisch polarisiert werden. Wenn die Alkalimetalle als einfach positiv geladene Ionen z. B. in Salzen vorliegen, dann sind sie mit wenigen Ausnahmen (wie z. B. LiF) auch gut wasserlöslich.

Alle Kerne der Alkalimetallatome haben ein elektrisches Kernquadrupolmoment. Die ⁷Li⁺-, ²³Na⁺-, ⁴¹K⁺-, Rb⁺-Ionen haben aber relativ große Kernquadrupolmomente von der Größenordnung 0,1 e · 10⁻²⁴ cm², so dass ihre Kernspinpolarisation in wässriger Lösung aufgrund der starken Quadrupolwechselwirkung relativ schnell, das heißt nach etwa 10 ms (Na⁺) bis 18 Sekunden (⁷Li⁺) zerfällt. ¹³³Cs⁺ hat zwar ein kleines Kernquadrupolmoment (4.10⁻³ e · 10⁻²⁴ cm²), die Kernspinpolarisation zerfällt aber trotzdem schnell aufgrund des großen Sternheimerfaktors. Der Sternheimerfaktor beschreibt die Verstärkung des elektrischen Feldgradienten über Stöße mit der Elektronenhülle des Cs-Ions.

Es wurde erkannt, dass unter diesen Gesichtspunkten der herausragende Kandidat das ⁶Li⁺-Ion ist. Dieses weist ein sehr kleines Kernquadrupolmoment (4,6 · 10⁻⁴ e · 10⁻²⁴ cm²) und einen kleinen Sternheimerfaktor auf. Darüber hinaus hat es ein kleines gyromagnetisches Verhältnis von 0.062 hz/T.

Daraus ergibt sich, dass die T₁-Zeiten vom ⁶Li⁺-Ion sehr lang sein können. Sie reichen von ca. 10 min in der wässrigen Phase bis zu über 2000 h für den ⁶LiD Festkörper (bei B = 0,4 T und T < 1 K).

Da hyperpolarisiertes ⁶Li⁺ vergleichsweise preiswert ist, einen lange T₁-Zeit aufweist und so klein ist, dass es nahezu verlustfrei in Bezug auf die Kernspinpolarisation in Zellen, poröse Materie, in Nano- bzw. Ionenkanäle diffundiert, ist es als NMR-Tracer eine bessere Alternative zu allen hyperpolarisierten Edelgasen.

Im Rahmen der Erfindung wurde weiterhin erkannt, dass sich Li-Atome bei hohen Dichten nicht direkt optisch pumpen lassen.
Wie Tabelle 1 zu entnehmen ist, liegen für das Lithiumatom die optischen D₁- und die D₂-Energieniveaus sehr nahe beieinander (nur 0,12 nm).
Dies bedeutet, dass bereits bei moderaten Puffergasdrucken (> 5000 Per He-Gas) und bei größeren Lithiumkonzentrationen (> 10¹² cm⁻³) die D₁- bzw. D₂-Linien von Lithium durch die Stoßverbreiterung überlappen. Dies hat zur Folge, dass z. B. bei zirkular polarisiertem Pumplicht beide Grundzustände des Li Atoms gleichzeitig entvölkert werden und damit die resultierende Gesamtpolarisation des Li-Grundzustandes praktisch gleich Null ist.

**Tabelle 1: Physikalische Eigenschaften der Alkalimetallatome,**

| | | | | | | |
|---|---|---|---|---|---|---|
| | mit | | | | | |
| | η*ₐₗₖ* : Isotopen-Häufigkeit | | | | | |
| | *I*: Kernspin | | | | | |
| | γ*ₐₗₖ* : Gyromagnetisches Verhältnis | | | | | |
| | D₁-Linie: Optischer Übergang von²*S*_{1/2}→²*R*_{1/2} | | | | | |
| | D₂-Linie : Optischer Übergang von ²*S*_{1/2}→²*P*_{3/2} | | | | | |
| | ω*_{hf}* : Hyperfein-Aufspaltung des Grundzustandes | | | | | |

| Species | *ηₐₗₖ* | *I* | *γₐₗₖ*/2π [kHz/G] | D₁-Linie [nm] | D₂-Linie [nm] | *ω*_{hf}/2π [MHz] |
|---|---|---|---|---|---|---|
| ⁶Li | 0,075 | 1 | 934,16 | 670,78 | 670,66 | 228,2 |
| ⁷Li | 0,925 | 3/2 | 700,621 | 670,78 | 670,66 | 803,5 |
| ²³Na | 1,0 | 3/2 | 700,621 | 589,59 | 588,99 | 1771,6 |
| ³⁹K | 0,931 | 3/2 | 700,621 | 769,90 | 766,49 | 461,72 |
| ⁴¹K | 0,0688 | 3/2 | 700,621 | 769,90 | 766,49 | 254,01 |
| ⁸⁵Rb | 0,7215 | 5/2 | 467,081 | 794,76 | 780,02 | 3035,73 |
| ⁸⁷Rb | 0,2785 | 3/2 | 700,621 | 794,76 | 780,02 | 6834,68 |
| ¹³³Cs | 1,0 | 7/2 | 350, 31 | 894, 35 | 852,11 | 9192,63 |

Im Zuge des erfindungsgemäßen Verfahrens wird deshalb vorteilhaft zunächst eine erste Alkalimetallsorte (AM), z. B. Rb oder K oder auch Cs optisch gepumpt. Diese erste Alkalimetallsorte wird bei moderaten Dichten von < 10¹⁵ cm⁻³ sehr effektiv gepumpt, das heißt der Polarisationsgrad ist sehr hoch (> 80%).

Im Rahmen der Erfindung wurde zudem erkannt, dass ein Spinaustausch zwischen dem optisch gepumpten Elektron des Alkalimetallatoms erster Sorte im Grundzustand und dem Elektron des Lithiumatoms im Grundzustand erfolgen kann, wobei die Dichte der Li-Atome sehr hoch sein kann. Dieser Polarisationsaustausch zwischen Rb und Li erfolgt mit einer Rate γₑₓ^{Rb, Li}.

Es wurde erkannt, dass indirekt optisches Pumpen zwischen den genannten Alkalimetallatomen und Lithiumatomen besonders gut funktioniert, sofern der sehr aggressive, heiße Lithiumdampf kontrolliert, das heißt weitgehend unter Vermeidung von Wandberührung und Li-Wandrelaxation, in die Probenzelle geleitet wird und in Wechselwirkung mit dem Alkalimetall erster Sorte, z. B. Rb, K oder Cs treten kann. Hierauf hin wurde eine Vorrichtung zur Durchführung des Verfahrens angepasst, wie weiter unten ausgeführt wird.

Verglichen mit dem Stand der Technik benötigt man vorteilhaft beim erfindungsgemäßen Verfahren für den Li Polarisations- und Akkumulationsprozess kein Vakuum und die Dichte der Li-Atome kann z. B. um einen Faktor 10³ höher als im Stand der Technik eingestellt werden.

Beim erfindungsgemäßen, indirekt optischen Pumpen mittels des ersten Alkalimetalls kann vorteilhaft die Li-Teilchenkonzentration in der Probenzelle sehr hoch gewählt sein, z. B. mindestens 10¹⁵ cm⁻³ bei einer Temperatur von - 600°C.
Vorzugsweise werden 10¹⁶-10¹⁸ cm⁻³ bei Temperaturen von ~ 750-1200°C eingestellt. Die Lithiumatome werden dennoch effizient mit einer moderaten Dichte der ersten Alkalimetallsorte indirekt polarisiert.
Hierzu ist es möglich, Cs, Rb ,K mit einer Dichte zwischen etwa 10¹² bis 10¹⁵ cm⁻³ (Temperaturen der Alkalimetallverdampfung: Cs: T = 70-180°C, Rb: T = 300-200°C, K: T= 200-300°C) einzusetzen, da dann die Spinaustauschrate γₑₓ^{AM, Li} größer wird, als die polarisationszerstörenden Raten γₛₐ der Alkalimetall-elektronenspins.

Durch das erfindungsgemäße Verfahren werden besonders vorteil-haft hyperpolarisierte Lithiumatome in entsprechend hoher Dichte und mit hohem Polarisationsgrad von > 50 % bereitge-stellt.

Die hyperpolarisierten Lithiumatome werden in einem weiteren Verfahrensschritt oxidiert. Auf diese Weise werden vorteilhaft die entsprechenden Mengen an Li⁺-Ionen bereit gestellt und akkumuliert.
Der Vorteil beider Oxidation besteht darin, dass die T₁-Zeiten der Kerne der Li-Ionen um Größenordnungen, z- 3. mindestens 10⁵-mal länger sind, als die T₁-Relaxationszeit der Li-Atome.

Auf diese Weise wird besonders vorteilhaft die Akkumulation von Li⁺-Ionen ermöglicht. Die Li⁺-Ionen können als hypörpolarisiertes MRT Kontrastmittel verwendet werden, indem sie in geeignete, insbesondere biokompatible Lösungsmittel eingelöst werden.

Ausgehend von dem in hoher Dichte vorliegenden polarisierten Lithiumdampf wird durch Oxidation dem Lithiumatomen je ein Elektron entfernt, ohne dabei die Li-Kernspinpolarisation zu zerstören.
Besonders vorteilhaft bleibt während des Elektronentransferprozesses die Kernspinpolarisation des Li-Atoms trotz der Redoxreaktion erhalten.

Hierzu wurde im Rahmen der Erfindung erkannt, die Hyperfeinkopplungskonstante der beteiligten Li-Atome zu nutzen.
Der Zusammenhang besteht darin, dass der Kernspin des ⁶Li-Atoms an sein Hüllenelektron mit einer Hyperfeinkopplungskonstanten von 228 MHz gekoppelt ist (siehe Tabelle 1). Dies bedeutet, dass eine Hyperfeinperiode der Hyperfeinwechselwirkung etwa 4,3 ns dauert. Da diese Periode mehr als 1000-mal länger ist, als die Zeit für den Elektronentransfer (einige ps), bleibt der Kernspin praktisch völlig unbeeinflusst und daher die Kernspinpolarisation erhalten. Auf diese Weise können große Mengen an ⁶Lithium Kernspinpolarisation erzeugt, akkumuliert und gespeichert werden.
Dabei kann ein Polarisationsgrad der Li-Kerne im Festkörper oder auch in einer geeigneten Flüssigkeit von 1-90% ohne weiteres erzielt werden.

Als Oxidationsmittel kommen z. B. D₂, H₂ oder Cl₂ -Gas in Betracht. Das Oxidationsmittel wird z. B. in den Ausgang der Probenzelle geleitet und oxidiert die hyperpolarisierten Lithiumatome zu Li-Molekülen, bzw. -Salzen. Die je nach Oxidationsmittel entstehenden polaren Lithiummoleküle (Salze), z. B. LiD, LiH, LiCl werden in eine Kühlfalle geleitet. Je nach Phase des Kühlmittels werden die Lithiummoleküle gelöst oder scheiden sich direkt als Lithiumsalz in Form eines Festkörpers in der Kühlfalle ab.
Insbesondere können die hyperpolarisierten ⁶Li⁺-Kerne im Festkörper eine extrem lange T₁-Zeit haben, die z.B. für LiD mehr als 2000 h beträgt bei einem Magnetfeld von 0,4 T und bei Temperaturen < 1 K. Bei T = 77 K beträgt T₁ ~ mehrere h.

Der weitere Verwendungszweck bestimmt die Art der im Anschluss an die Erzeugung dieser polarisierten Lithium Ionen vorzunehmenden Behandlung.

Das Potential der Erfindung ist damit aber noch keineswegs erschöpft.
Vielmehr ist es möglich, dass so hergestellte hyperpolarisierte Li-Salz zur Herstellung anderer hyperpolarisierter Substanzen in flüssigen oder festen Zuständen zu nutzen, indem die Kernspinpolarisation der Li⁺-Ionen auf einen Kernspin eines Anions übertragen wird, wie unten ausgeführt wird.

Ein allgemeines Verfahren hierzu umfasst die Schritte:
- Lithiumatome werden durch optisches Pumpen von einer ersten Alkalimetallsorte in einer Probenzelle mittels Laserlicht und Spinaustausch vom optisch gepumpten Elektron des ersten Alkalimetallatoms auf das Elektron des Lithiumatoms hyperpolarisiert,
- die Lithiumatome werden zu Li⁺-Ionen oxidiert, wobei die Kernspinpolarisation der Lithium-Ionen erhalten bleibt,
- die Polarisation der Li⁺-Ionen wird auf den Kernspin eines Anions A in dem entsprechenden LiₓA_{y} -Festkörper (x, y natürliche Zahlen) übertragen.

Die nachfolgenden Ausführungen beziehen sich somit entsprechend auf das Verfahren gemäß Hauptanspruch und Nebenanspruch.

Für die Hyperpolarisation des Lithiumatoms umfasst das in die Probenzelle eingeleitete Gemisch neben der ersten Alkalimetallsorte und Lithium z. B. auch N₂ und ⁴He. Mittels zirkular polarisiertem Laserlicht wird zunächst die D₁-Linie der ersten Alkalimetallsorte im Dampf optisch angeregt und der Spin des Valenzelektrons der Alkalimetallatome in hohem Grade polarisiert. Das gesamte Gemisch aus Alkalimetall- und Lithiumdampf sowie N₂ und ⁴He wird durch die geheizte Probenzelle kontinuierlich geleitet. Der beigefügte N₂ unterdrückt die Fluoreszenz der ersten Alkalimetallsorte als ein sogenanntes Quench-Gas.

Das ⁴He-Gas dient als Puffergas und zur Druckverbreiterung der D₁-Linie der Atome der ersten Alkalimetallsorte und so für eine effektive Absorption der eingesetzten, breitbandigen Laserstrahlung.

Das Gemisch kann in einer besonders vorteilhaften Ausgestaltung der Erfindung ³He umfassen, wobei der Kernspin des ³He-Gases über die indirekt optisch gepumpten Li-Atome polarisiert wird. Die Polarisation erfolgt über die ⁶Li (bzw. ⁷Li) -³He-Hyperfeinwechselwirkung. Vorteilhaft hierbei ist, dass bei z. B. 10¹⁷ Lithiumatomen, die Geschwindigkeit der Aufpolarisation der ³He-Kerne wesentlich größer ist (Spin-up-Zeit: <1 h).

Sehr vorteilhaft ist es möglich, als Pumplaser einen preisgünstigen Halbleiterlaser mit typischerweise 1-4 nm optischer Linienbreite einzusetzen.

Nach Durchströmen der Probenzelle wird das hyperpolarisierte Lithium mit einem Oxidationsmittel, wie beschrieben, oxidiert und die entstehenden Li-Moleküle in einem Abscheider und in einem Magnetfeld > 0,05 T als Li-Salz abgeschieden und über die Dauer des Verfahrens akkumuliert. Andere gasförmige Produkte werden z. B. als Abgas abgeführt.

Mit dem Verfahren können vorteilhaft ⁶Li-Atome wie auch ⁷Li-Atome hyperpolarisiert und in ihre entsprechenden Ionen oxidiert und akkumuliert werden.

Generell sollen die Lithiumatome mit einer Dichte von mindestens 10¹⁴ cm⁻³ und die erste Alkalimetallsorte mit einer Dichte von mindestens 10¹² cm⁻³ in die Probenzelle geleitet und optisch gepumpt werden. Es erfolgt sodann der Spinaustausch.

Bei derartig hohen Li-Konzentrationen ist gewährleistet, dass in dem durch die langen T₁-Zeiten der hyperpolarisierten Li-Verbindungen gegebenen maximalen Akkumulationszeiten eine hinreichende Menge an hyperpolarisierten Li-Verbindungen produziert werden kann.

Um Lithium in die Gasphase zu überführen, wird die Hyperpolarisation bei > 500 °C, insbesondere bei etwa 900 °C durchgeführt.
Mit zunehmender Temperatur wird die Dichte an Lithiumatomen in der Probenzelle größer und kann in Abhängigkeit von der Temperatur gezielt eingestellt werden.

Die Lithiumatome werden durch Zugabe von Oxidationsmitteln, wie z. B. Cl₂, J₂, Br₂, D₂, H₂ oder organischen Oxidationsmitteln zu Li⁺-Ionen oxidiert. Durch die Oxidation wird vorteilhaft je nach Wahl des Oxidationsmittels das entsprechende Lithiumsalz erzeugt. Die Li-Atome werden durch fortdauernde Oxidation und Einleiten des Gasgemisches in eine Kühlfalle mit z. B. N₂ oder H₂O als Kühlmittel in einem Magnetfeld > 0,05 T als entsprechendes Lithiumsalz zu relevanten Mengen akkumuliert (z. B. auf bis zu 10¹⁹).

Ein Polarisationsgrad der Li-Kerne im Festkörper oder auch in einer geeigneten Flüssigkeit von 1-90% kann so ohne weiteres erzielt werden.

Das erfindungsgemäß erzeugte Lithiumsalz kann dann ganz besonders vorteilhaft als Polarisationsmedium zur Hyperpolarisation von Kernen eines anderen Anions eingesetzt werden. Die Kernspins der Anionen weisen vorteilhaft lange T₁-Zeiten auf und können daher gespeichert oder gegebenenfalls in Lösungsmitteln gelöst für bildgebende Verfahren oder NMR-Spektroskopie genutzt werden.

Dabei können insbesondere die für die Kernspinresonanz so wichtigen Kerne ¹³C, ³¹P, ²⁹Si und einige Al-Kerne, die sich durch lange T₁-Zeiten auszeichnen, auf Polarisationsgrade von mehr als 1 % und in relevanten Mengen von z. B. 10¹⁹ Atomen, Ionen oder Moleküle erzeugt werden. Es ist denkbar, auf diese Weise Polarisationsgrade > 50 % zu erzeugen.

Bringt man z. B. erfindungsgemäß hergestelltes kernspinpolarisiertes ⁶Li⁺Cl⁻ in wässriger Lösung zusammen mit anderen Anionen A, (mit A = z. B. CO₃²⁻, SiO₄⁴⁻, PO₄³⁻, Al₂O₃), dann erhält man z. B. durch anschließendes Verdampfen des Lösungsmittels unter anderem die entsprechenden LiₓA_{y}-Salze Li₂CO₃, Li₄SiO₄ und Li₃PO₄. Man beachte, dass dieses Verfahren nur mit ⁶Li als Polarisationsmedium möglich ist, da die Einlösungs- und Verdampfungsprozesse einige Minuten dauern und in dieser Zeit die Lithiumkernspinpolarisation nicht verloren gehen sollte (T₁ ⁶Li in H₂O: ~ 10 min) .

Besonders vorteilhaft für dieses Verfahren sind also alle Kerne mit langen longitudinalen T₁-Zeiten, das heißt für die Kerne ⁶Li, ¹³C, ²⁹Si und ³¹P etc., in dem LiₓA_{y}-Festkörper oder in Lösung. Besonders vorteilhaft liegen Die T₁-Zeiten der genannten Kerne im Bereich von Minuten bis Stunden. Beispiele für T₁-Zeiten für Li-Verbindungen sind in Tabelle 2 aufgelistet.

**Tabelle 2: T₁-Relaxationszeiten in Festkörpern für die Kerne ⁶Li, ⁷Li, ¹³C, ³¹P und ²⁹Si.**

| Verbindung | Kern | T₁-Zeit [min] |
|---|---|---|
| LiF | ⁷Li | 5 |
| LiCl | ⁷Li | 40 |
| LiD | ⁶Li | > 60 |
| Li₂CO₃ | ¹³C | > 20 |
| XPO₄ | ³¹P | > 1 |
| XSiO₄ | ²⁹Si | > 30 |

Im ionischen LiₓA_{y}-Festkörper kann nun mittels des Kreuzpolarisations- oder auch des Fieldcyclingverfahrens die große Li⁺-Kernspinpolarisation mit hoher Effizienz auf die ¹³C, ²⁹Si bzw. ³¹P Kernspins übertragen werden.

Dabei werden bis zu 50% der Li-Kernspinpolarisation auf die anderen Kerne übertragen.

Die Kreuzpolarisation ist ein Standardverfahren bei dem mittels zweier Radiofrequenzpulse kohärent Polarisation von einer Spinsorte A auf eine Spinsorte B übertragen wird. Hierbei sollte bei großen Magnetfeldern die so genannte Matching-Bedingung, auch Hartmann-Hahn-Bedingung genannt, für die beiden Spinsorten erfüllt sein. Die Hartmann-Hahn-Bedingung ist erfüllt, wenn für die Amplituden der beiden Radiofrequenzpulse H₁^{A} und H₁^{B} der Spinsorten A und B die Bedingung γ_{A} H₁^{A} = γ_{B} H₁^{B} erfüllt ist. Hierbei sind γ_{A} und γ_{B} die gyromagnetischen Verhältnisse der Spinsorten A und B. Beim Fieldcyclingverfahren wird die Matching-Bedingung durch schnelles Herunterschalten des Magnetfeldes auf den Wert 0 erreicht. Dabei erfolgt ein kohärenter Transfer der Spinpolarisation zwischen A und B.

Sowohl die Kreuzpolarisation als auch das Fieldcycling funktionieren nur, wenn die betrachteten Spins permanent dipolar gekoppelt sind, das heißt die entsprechenden Spins dürfen sich nicht relativ zueinander bewegen. Dies ist in der Praxis am besten für den Festkörper erfüllt. Beispielsweise ist der Gewinnfaktor für die ¹³C Kernmagnetisierung, die an ein einzelnes Proton dipolar gekoppelt ist, nach einem Prozess der Kreuzpolarisation um den Faktor 4 verstärkt.

Die auf diese Weise kernspinpolarisierten Anionen A können dann ihrerseits wegen ihrer langen longitudinalen T₁-Zeiten gespeichert oder in ein geeignetes Lösungsmittel eingebracht werden, wo sie dann als NMR- bzw. MRT-Sonden eingesetzt werden können.

Durch das Verfahren wird erstmalig je nach Art des gewählten Festkörpers bzw. Lösungsmittels ein Kontrastmittel für MRT- bzw. NMR-Untersuchungen bereit gestellt, das T₁-Zeiten im Bereich von 10 min (z. B. ⁶Li+ in Wasser) bis einige Stunden (z. B. ⁶Li⁺ in LiD, ²⁹SiO₄-Festkörper) und sogar noch länger aufweist.

Das Verfahren wird vorteilhaft so angewendet, dass die Bestandteile des Gasgemisches (⁴He-, N₂-, Lithium- und Alkalimetalldampf) derartig in die Probenzelle geleitet werden, dass das Gemisch die Innenwände der Probenzelle nicht oder nur in geringem Umfang berührt.
Hierzu kann das Gasgemisch als Freistrahl in die Probenzelle geleitet werden. Mit dem Begriff Freistrahl ist ein sich in der Probenzelle aufweitender oder ein abgeschirmter Strahl umfasst, welcher die Innenwände der Probenzelle nicht oder in geringerem Umfang als gemäß Stand der Technik, berühren soll. Es ist hierzu denkbar, einen schützenden Mantelstrom aus einem inerten Gas z. B. N₂ und /oder ⁴He zur Abtrennung des Gemisches von den Innenwänden in die Probenzelle zu leiten.

Derartige Maßnahmen sind sinnvoll, da heißer Lithium-Dampf äuβerst reaktiv ist.

Das Laserlicht kann vorzugsweise senkrecht zur Strömungsrichtung des in der Probenzelle fließenden Gemisches in die Probenzelle eingestrahlt werden. Das zum optischen Pumpen notwendige Magnetfeld ist parallel zur Ausbreitungsrichtung des Lasers zu wählen. Dann können die erzeugten Lithiumatome ohne räumliche Umwege bzw. Umleitungen gepumpt, oxidiert und als Ion abgeschieden werden.

Eine erfindungsgemäße Vorrichtung besteht aus Saphir oder Saphir beschichtetem Quarzglas oder aus anderen transparenten Lithium- und temperaturbeständigen Materialien als Innenauskleidung der Probenzelle.

Es werden vorteilhaft diejenigen Innenwände der Probenzelle Li resistente Materialien umfassen, welche in Kontakt mit dem heißen Li-Dampf geraten können.

Die Vorrichtung kann mindestens ein Mittel aufweisen, das die Bestandteile des Gemisches aus optisch pumpbarer Alkalimetall-Spezies und zu hyperpolarisierenden Kernen und/oder anderen inerten Gasen derartig in die Probenzelle leitet, dass das Gemisch die Innenwände der Probenzelle nicht berührt.

Hierzu kann die Vorrichtung vorteilhaft durch mindestens eine Düse als Mittel gekennzeichnet sein.

Derartige Mittel bilden bei der Injektion des Gemisches in die Probenzelle einen sich aufweitenden Freistrahl aus.

Zudem kann das oder die Mittel einen vor Wandkontakt schützenden Mantelstrom für das Gemisch ausbilden.

In der Vorrichtung zur Hyperpolarisation der Lithiumatome sind der oder die Laser vorteilhaft so angeordnet, dass das Laserlicht senkrecht zur Flussrichtung des Gemisches in die Probenzelle eingestrahlt wird.

Das oder die Eintrittsfenster der Probenzelle für das Laserlicht weisen dabei einen größtmöglichen Abstand zum Eingang der Probenzelle für die Alkalimetall Spezies auf.

Die Vorrichtung weist mindestens einen Vorratsbehälter für Alkalimetalle auf. Besonders vorteilhaft ist eine Anordnung in der mindestens zwei Vorratsbehälter angeordnet sind: ein Vorratsbehälter für eine erste Alkalimetallsorte sowie mindestens ein weiterer für Lithium.

Die Vorrichtung weist in einer weiteren vorteilhaften Ausgestaltung der Erfindung mindestens zwei Heizsysteme auf: eines für den Vorratsbehälter des ersten Alkalimetalls, das zweite für den Vorratsbehälter umfassend Lithium.

Im Weiteren wird die Erfindung an Hand von Ausführungsbeispielen und der beigefügten Figuren näher beschrieben.

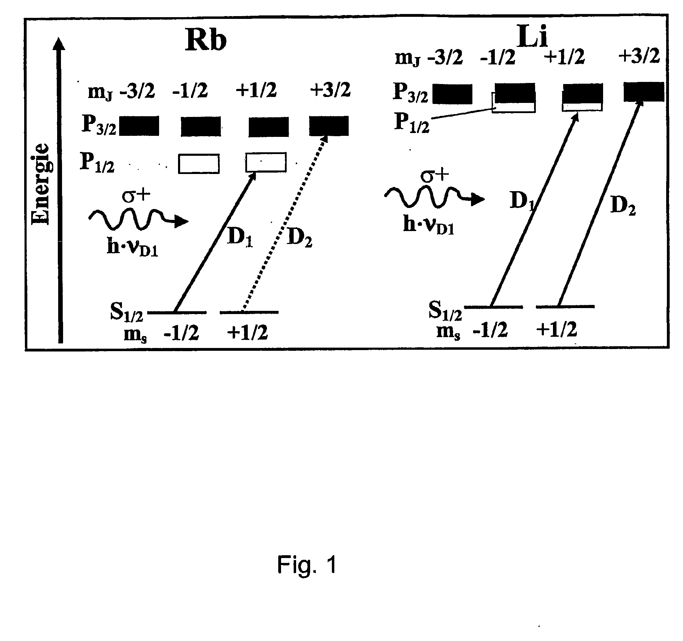

Fig. 1 zeigt schematisch das Termschema von Rb und Li. Wie erkennbar, sind bei Rb und für Gasdrucke < 10 bar die D₁ und die D₂-Linie energetisch getrennt, das heißt es wird nur die D₁-Linie gepumpt. Dagegen überlappen bei Li die oberen Energieniveaus der D1- und D₂-Übergänge; daher werden beide Grundzustandniveaus leergepumpt.

Wie aus Tabelle 1 ersichtlich ist, liegen für Li die optischen D₁-und die D₂-Energieniveaus sehr nahe beieinander. Das heißt, dass bei schon moderaten Puffergasdrucken (> 50 mBar) und bei größeren Li-Konzentrationen die D₁- bzw. D₂-Linien durch die Stoßverbreiterung überlappen. Daher lassen sich Li-Atome in der Gasphase nicht direkt bei höheren Drucken bzw. bei höheren Konzentrationen optisch pumpen. Dies bedeutet, dass z. B. bei zirkular polarisiertem Pumplicht beide Grundzustände (S = +1/2, S = -1/2) des Li Atoms gleichzeitig gepumpt werden und damit die resultierende Gesamtpolarisation des Li Grundzustandes praktisch gleich Null ist.

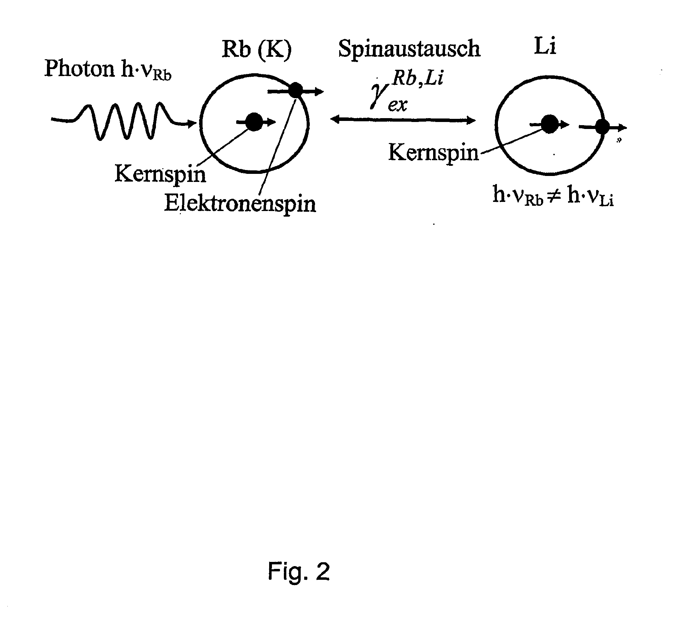

Fig. 2 bis 3 zeigen schematisch das erfindungsgemäße Prinzip der Hyperpolarisation der Lithiumatome und die anschließende Oxidation als Grundlage der Akkumulation und Erzeugung weiterer hyperpolarisierter Kerne.

Li wird erfindungsgemäß nicht direkt, sondern indirekt mit einer zweiten Alkalimetallsorte optisch gepumpt. Der Mechanismus dieses indirekten optischen Pumpens ist in der Fig. 2 dargestellt.

Eine weitere Alkalimetallsorte (Rb, K, Cs), die effektiv gepumpt werden kann, wird durch den Laser polarisiert. Durch Stöße erfolgt ein Spinaustausch zwischen dem optisch gepumpten Elektron des Alkalimetallatoms im Grundzustand und dem Elektron des Li-Atoms im Grundzustand. Dieser Polarisationsaustausch zwischen Rb und Li erfolgt mit einer Rate γₑₓ^{Rb, Li}. Dieser Elektron-Elektron Spinaustausch erfolgt vorteilhaft sowohl bei beliebigen Puffergasdrucken von z. B. ⁴He, als auch bei großen Teilchendichten der Li-Atome.

Aus dem Stand der Technik sind keine Experimente mit indirekt optischen Pumpen zwischen Alkalimetallatomen und Li-Atomen bekannt.
Haupthindernis dafür sind technologische Schwierigkeiten, die mit dem sehr aggressiven heißen Li-Dampf verbunden sind. Dies hat bisher eine Auseinandersetzung mit der Hyperpolarisation von Lithium verhindert.

Ein großer Vorteil des indirekt optischen Pumpens ist aber, dass die Li-Teilchenkonzentration sehr hoch sein kann (z. B. 10¹⁷ cm⁻³) und dennoch effizient mit einer moderaten Rb-Dichte (z. B. 10¹⁵ cm⁻³) indirekt polarisiert werden kann.

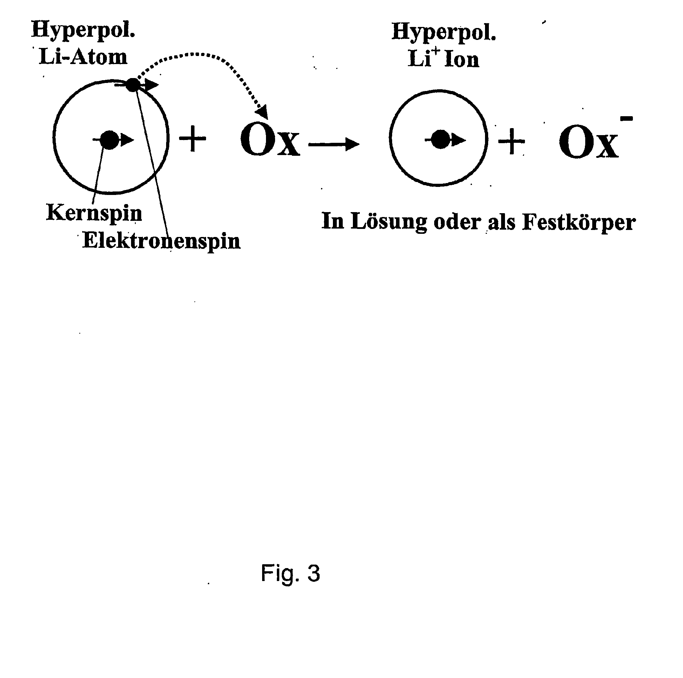

Ausgehend von dem so polarisierten Li-Dampf mit hoher Dichte erfolgt eine Oxidation des Lithiumatoms (siehe Fig. 3).

Der entscheidende Punkt bei dem Elektronenentzug des Li-Atoms durch das Oxidationsmittel Ox ist, das während des Elektronentransferprozesses die Kernspinpolarisation des Li-Atoms trotz der Redoxreaktion erhalten bleibt.

Gemäß Tabelle 2 ist der Kernspin des ⁶Li-Atoms an sein Hüllenelektron mit der Hyperfeinkopplungskonstanten von 228 MHz gekoppelt. Dies bedeutet dass eine Hyperfeinperiode der Hyperfeinwechselwirkung ca. 4,3 ns dauert. Da diese Periode mehr als 1000-mal länger ist, als die Zeit für den Elektronentransfer, bleibt der Kernspin praktisch völlig unbeeinflusst und daher die Kernspinpolarisation erhalten. Unter der Annahme, dass zwar weitere Relaxationskanäle, z. B. die Spin-Rotationskopplung des Lithiummoleküls existieren, aber die Einlösung des Li-Ions in die wässrige Phase bzw. die Bildung des ionischen Festkörpers (Lithium-Salz) schneller erfolgt, als die T₁-Zeit der Lithiummoleküle bzw. Salze, bleibt letztendlich die ⁶Li-Kernspinpolarisation in der Verbindung oder in Lösung weitgehend erhalten.
Eine ausreichende Menge an gespeicherter ⁶Li Kernspinpolarisation wird erreicht.

Mit diesem Kombinationsverfahren, nämlich Hybridoptisches Pumpen mit anschließendem Elektronentransferprozess (Oxidation) wird ganz besonders vorteilhaft ein Polarisationsgrad der Li-Ionen von mehr als 50 % und bis zu 90% erzielt.

Nachfolgend wird das Verfahren am Beispiel der Herstellung, Akkumulierung und Speicherung hyperpolarisierter ⁶Li-Ionen durch optisches Pumpen von Rb noch im Detail ausgeführt.

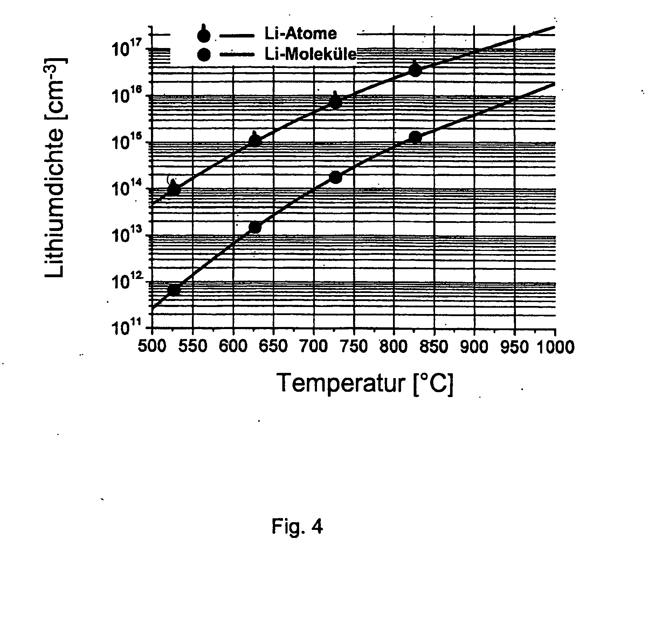

Es bedarf zunächst der Erzeugung eines Gasstromes in Form aus He, N₂, Rb und Li mit genügend hoher Alkalimetalldichte. Die Li-Dichte des Gasstromes kann z. B. etwa 10¹⁷ cm⁻³ betragen. Dies entspricht einer Verdampfungstemperatur von - 900 °C. Für die Rb-Dichte genügen ca. 10¹⁵ cm⁻³, entsprechend T ~ 200 °C. Die Li-Dichte als Funktion der Temperatur ist in der Fig. 4 dargestellt.

Heißer Li-Dampf greift nahezu alle Behälterwände der optischen Pumpzelle an. Normales Pyrex- bzw. Duranglas wäre daher völlig ungeeignet. Denkbar als Materialien für die optische Pumpzelle ist z. B. Quarzglas mit einer Innenbeschichtung aus Saphir (Al₂O₃) oder eine Saphirzelle als solche.

Der indirekt optisch polarisierte Li-Dampf kann ohne Verlust der Polarisation als Ionen in einen Festkörper überführt werden. Beispielsweise kann das Li-Atom mit einem gasförmigen Reaktanten Ox, wie z. B. Cl₂ oder D₂-Gas, reagieren und als festes Salz (LiD oder LiCl) abgeschieden werden. Die longitudinale T₁-Relaxationszeit des Li-Ions im Festkörper sollte so lange wie möglich sein, um die Polarisationsverluste während der Akkumulationszeit zu minimieren.

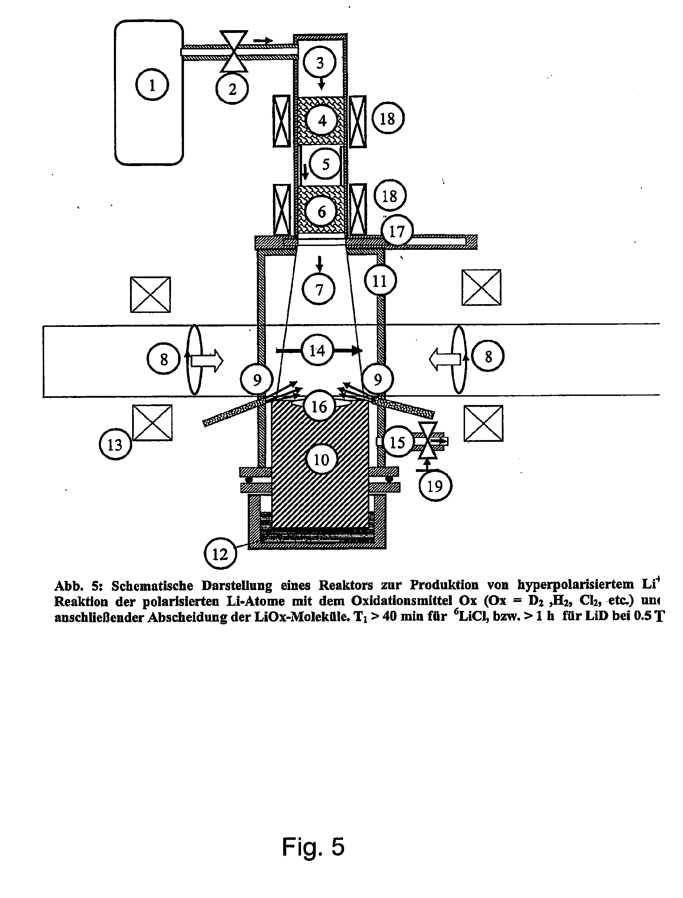

Fig. 5 zeigt einen erfindungsgemäßen Rb-Li-Jet-Polarisator, der an den Herstellungsprozess der Hyperpolarisation von Lithium mittels indirekt optischen Pumpens von Alkalimetallen angepasst wurde.

Bei dem Verfahren wird aus einem Behälter 1, welcher ca. 0,1 bar N₂-Gas und 1-10 bar ⁴He-Gas enthält, das Gasgemisch 3 in ein Rb-Reservoir 4 geleitet. Der Stickstoff dient zum Quenchen beim Optischen Pumpen. Mittels einer Spule 18 wird induktiv das Rb-Reservoir auf 200 °C aufgeheizt und damit eine Rb-Dichte von etwa 10¹⁵ cm⁻³ erzeugt. Der Gasstrom 5 umfassend Rb, ⁴He und N₂ gelangt in ein Li-Reservoir 6, das mit einer weiteren Spule 18 auf eine Temperatur von etwa 900 °C aufgeheizt wird. Dies entspricht etwa einer Li-Dichte von 10¹⁷ cm⁻³. Der so erhaltene Gasstrom aus Li, Rb, ⁴He und N₂ wird durch eine Düse als Freistrahl 7 in die optische Pumpzelle aufgeweitet und expandiert. Die Düse weist einen Durchmesser von beispielsweise 15 mm auf. Der Freistrahl 7 expandiert in der optische Pumpzelle bzw. Probenzelle 11, wobei der Freistrahl 7 nur wenig mit den Wänden der Zelle 11 in Kontakt kommt. Hierdurch wird eine Reaktion bzw. die Depolarisation der Li- bzw. der Rb-Atome an den Wänden vermieden.

Die Probenzelle besteht erfindungsgemäß aus Al₂O₃ oder Al₂O₃ beschichtetem Quarzglas oder anderen transparenten Lithium- und temperaturbeständigen Materialien.

Typische Gasflussgeschwindigkeiten des Gemisches liegen bei etwa 100 cm³ min⁻¹_{.}

Unmittelbar hinter dem Eintritt in die Probenzelle 11 werden die Rb-Atome des Gasstroms 7 mit senkrecht zum Strahl 7 eintretendem, zirkular polarisiertem Licht 8 zweier Laser auf der Rb-D₁-Linie optisch aufpolarisiert. Die optisch gepumpten Rb-Atome befinden sich in einem von einem Hallbachmagneten 13 erzeugten Magnetfeld 14, dessen Feldrichtung parallel zur Einstrahlrichtung des Lasers 8 und senkrecht zur Richtung des Gasstromes orientiert ist. Die polarisierten Rb-Atome polarisieren den Li-Grundzustand mittels Elektron-Elektron-Spinaustausch. Dieser Austauschprozess geschieht schnell, typischerweise in 100 µs oder schneller; die Aufpolarisierungszeiten durch Spinaustausch für die Li-Atome sind wesentlich kürzer, als die longitudinale Spinrelaxationszeit der Rb- bzw. Li-Elektronen. Da der ⁴He-Gasdruck frei wählbar ist (0,1-10 bar) können preiswerte breitbandige, ca. 2 nm Halbleiterlaser zum optischen Pumpen verwendet werden.

Im Weiteren wird nun dem hyperpolarisierten Gasgemisch umfassend Rb und Li ein Oxidationsmittel, z. B. D₂ oder H₂, Cl₂ etc., zugemischt. Das Oxidationsmittel wird über seitlich an der Probenzelle 11 angeordnete Zuleitungen 9 in einem Winkel von etwa 45° entgegen der Strömungsrichtung zugemischt. Wie erkennbar, erfolgt die Zumischung am Ausgang der Probenzelle 11.

Das Oxidationsmittel D₂ oxidiert die Lithium- bzw. Rb-Atome, wobei LiD- bzw. RbD- Moleküle entstehen. Diese Moleküle gelangen in eine mit flüssigen N₂ oder mit Wasser 12 gekühlten Falle 10, wo sie sich als LiD-Festkörper abscheiden. Im Falle von H₂ oder Cl₂ als Oxidationsmittel wird entsprechend LiH oder LiCl abgeschieden.

Der Abscheideprozess erfolgt in einem Magnetfeld größer als 0,1 T (s. Hallbachmagnet 13), da sonst die T₁-Zeiten des Li-Kerns im Festkörper zu kurz wären. Bei Feldern > 0,1 T ist der Vorteil die besonders lange T₁-Zeit des ⁶Li- (bzw. ⁷Li)-Ions im Festkörper, die z. B. für ⁶LiCl bei 0,4 T und 77 K mehr als eine Stunde beträgt. Eine experimentelle Bestimmung der T₁-Zeit für ⁶LiD bei 77 K steht noch aus; bekannt ist die T₁-Zeit von ⁶LiD bei T < 1 K und 0,4 T: sie beträgt ca. 2000 h. Mittels des erfindungsgemäßen Verfahrens werden also völlig neue Perspektiven eröffnet.

Die gasförmigen Produkte (He, N₂, H₂, Cl₂, HD evtl. O₂) werden über eine Abgasleitung und über ein Nadelventil 15 abgeführt. Über das Nadelventil 15 kann der kontinuierliche Gasfluss kontrolliert werden. Im letzten Schritt kann man z. B. hyperpolarisiertes LiD (LiCl) mit Wasser vermischen, wobei man hyperpolarisierte Li⁺- bzw. OH⁻ (Cl⁻) -Ionen in Lösung und entwichen-des HD-Gas erhält.

Auf die geschilderte Weise ist eine akkumulierte Gesamtzahl hyperpolarisierter Li⁺-Ionen von 5 10²⁰ möglich.

Als Ausführungsbeispiel für das verfahren sei die Akkumulation von hyperpolarisiertem ⁶LiCl-Salz mit Übertragung auf Anionen mitsamt einem typischen Anwendungsbeispiel aus der Medizin vorgestellt.

Die Flussräte des hyperpolariserten ⁴He-, Li-, N₂-. Rb-Gasstromes 7 mit einer Li-Dichte ~10¹⁷cm⁻³ beträgt 100 cm³/min bei 7000hPer Gasamtdruck. Ein ⁴He-Cl₂-Gasgemich mit ebenfalls 7000hPer Gesamtdruck und einem Cl₂-Partialdruck von 0,1 bar strömt über Zuleitungen 9 kontinuierlich in den Gasraum der Probenzelle 11, wobei es mit den hyperpolarisierten Rb, Li-Atomen zu LiCl bzw. RbCl-Molekülen reagiert. Die RbCl bzw. LiCl-Moleküle scheiden sich nun am kalten Kühlkörper 10 als Salz ab. Bei einer Akkumulationszeit von z. B. 10 min werden so 1000 cm³ Li-Dampf mit einer Dichte von 10¹⁷cm⁻³ in Form von festem LiCl abgeschieden. Dies entspricht einer akkumulierten Gesamtzahl von etwa 10²⁰ hyperpolarisierten Li-Ionen.

Das hyperpolarisierte LiCl-Salz kann bei Bedarf z. B. in gekühltem Wasser vollständig aufgelöst werden und direkt als Li-NMR-Sonde einer Probe zugeführt, z. B. einem zu untersuchenden Patienten injiziert werden. Da die T₁-Zeit von ⁶Li in Wasser etwa 10 min beträgt, kann z. B. das ⁶Li⁺-Ion ohne großen Polarisationsverlust in das menschliche Gehirn oder in ein Organ gelangen und dann mit Li-MRT untersucht werden.

Als alternative Oxidationsmittel kommen im Prinzip alle Halogenide in Frage, also J₂, Br₂, Cl₂, F₂-Gas und eventuell auch einfache organische Moleküle wie z. B. CH₄. Nahezu alle Li-Halogenidsalze haben lange T₁-Zeiten (z.B. T₁ = 40 min für ⁷LiCl). Es eröffnet sich hier die gesamte Chemie möglicher Li-Oxidationsprozesse bzw. Elektronentransferprozesse.

Ihre Eignung als hyperpolarisierte Li-Salze in der Kernspinresonanz hängt von den jeweiligen Li-T₁-Zeiten, von ihrer Löslichkeit in dem ausgewählten Lösungsmittel und schließlich von ihrer Biokompatibilität ab.

Zur Hyperpolarisation anderer wichtiger Kerne für die NMR bzw. MRT, wie z.B. ¹³C, ²⁹Si oder ³¹P, werden die hyperpolarisierten Li-Ionen als Polarisationsmedium genutzt.
Bringt man beispielsweise kernspinpolarisiertes LiCl in Lösung zusammen mit anderen Anionen A, (z. B. A = CO₃²⁻, SiO₄⁴⁻, PO₄³⁻), so erhält man durch anschließendes Verdampfen des Lösungsmittels unter anderem die entsprechenden LiₓA_{y}-Salze Li₂CO₃, Li₄SiO₄ und Li₃PO₄. Die longitudinalen T₁-Zeiten der ⁶Li, ¹³C, ²⁹Si und ³¹P Kerne in dem LiₓA_{y} Festkörper sind lang und liegen im Bereich von einigen Minuten bis Stunden. Beispiele für T₁-Zeiten der betrachteten Kerne sind in Tabelle 2 aufgelistet.

Im ionischen LiₓA_{y}-Festkörper kann nun mittels des Kreuzpolarisations- oder des Fieldcyclingverfahrens die große Li-Kernspinpolarisation mit großer Effizienz auf die ¹³C, ²⁹Si bzw. ³¹P Kernspins übertragen werden. Dabei kann typischerweise 50% der Li-Kernspinpolarisation auf die anderen Kerne übertragen werden. Die auf diese Weise kernspinpolarisierten Anionen A können dann wegen ihrer langen T₁-Zeiten wieder in ein geeignetes Lösungsmittel eingebracht werden, wo sie dann als NMR bzw. MRT-Sonden eingesetzt werden können.

Die in den Ausführungsbeispielen genannten Reaktanden und Verfahrensschritte sind selbstverständlich nur beispielhaft zu verstehen.
Ein Fachmann kann ohne weiteres einzelne Verfahrensschritte und Parameter adaptieren (Temperaturen, Dichten, Fließgeschwindigkeiten, Reaktanden) um zu anderen Lithiumsalzen oder Kernen zu gelangen. Eine Adaptation an spezifische Fragestellungen und Untersuchungsobjekte ist also ohne weiteres möglich.

In Bezug auf das Lösen der Verbindung in biokompatiblen und anderen Lösungsmitteln zum Zwecke der Herstellung von Kontrastmittel und die Methode der Kreuzpolarisation bzw. des Fieldcyclings sei auf die Literatur verwiesen.

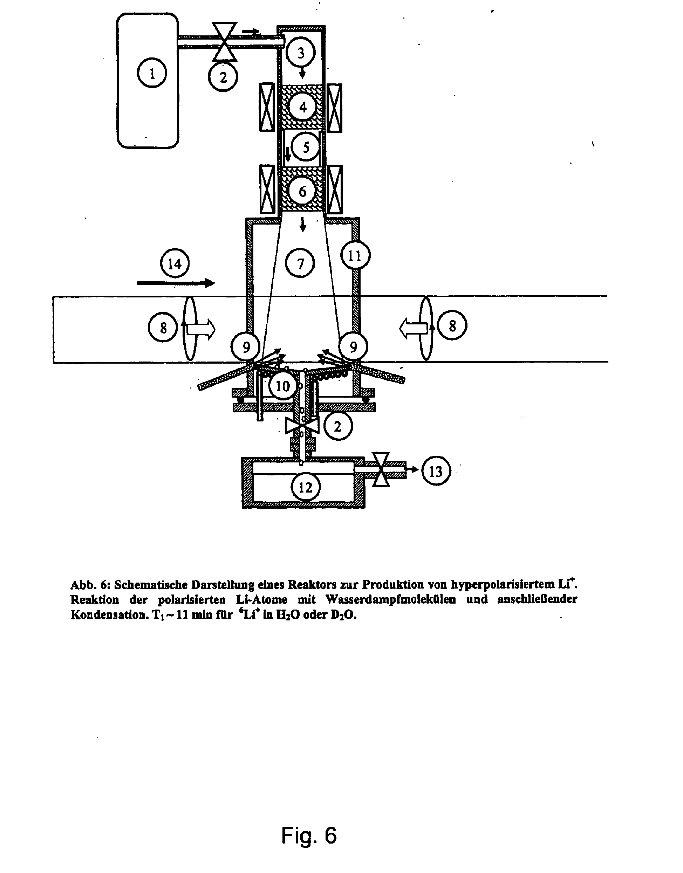

Denkbar ist beispielsweise auch die in Fig. 6 gezeigte Vorrichtung, mit der das erfindungsgemäße Verfahren zur Hyperpolarisation von Lithiumatomen ebenfalls durchgeführt werden kann.

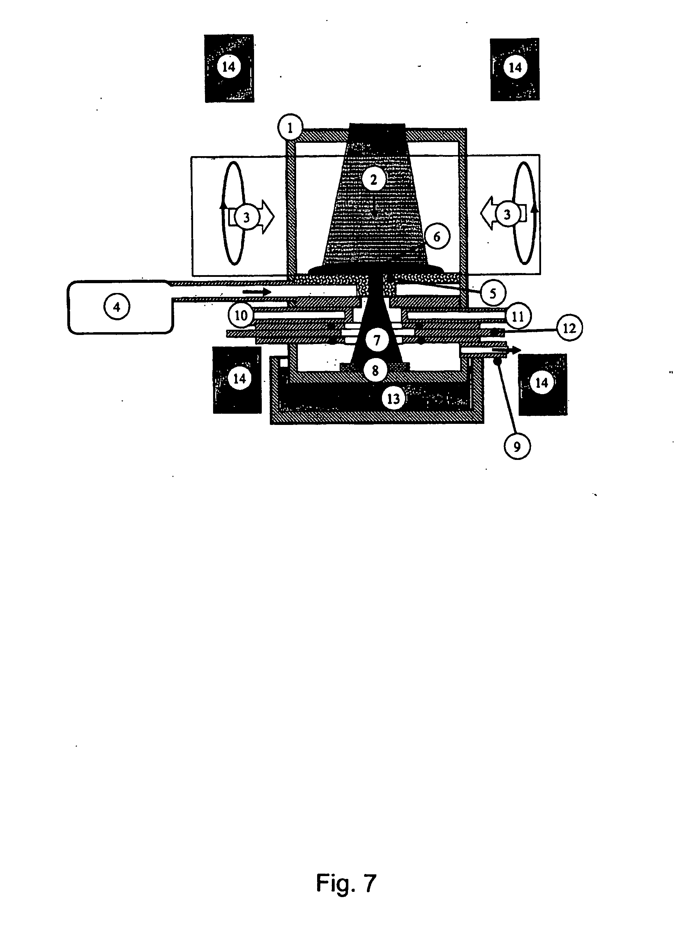

Fig. 7 zeigt eine Ausschnittvergrößerung aus der Reaktionszone, in der das hyperpolarisierte Lithium oxidiert wird. Danach wird vorgeschlagen, an der Stelle oberhalb der Zuleitung des Oxidationsmittels poröse Wände 5 vorzusehen, über die das Oxidationsmittel z. B. als hochkonzentrierte Flüssigkeit zugeführt wird. Die poröse Wand 5 führt zur feinen Dispergierung und Verwirbelung sowie Ausbildung einer Reaktionsschicht. Die poröse Wand lässt in der Mitte der Probenzelle (z. B. Saphirrohr) eine Öffnung frei, durch die die Gas- und Reaktionsprodukte hindurch treten und als Lithiumsalz 8 abgeschieden werden.

Wie auch für die anderen Ausführungsbeispiele werden Li-Atome durch fortdauernde Oxidation und Einleiten des Gasgemisches in die Kühlfalle mit z. B. N₂ oder H₂O als Kühlmittel in einem Magnetfeld > 0,05 T als entsprechendes Lithiumsalz zu relevanten Mengen akkumuliert (z. B. auf bis zu 5·10²⁰).

Für Fig. 7 ist denkbar, an dieser Stelle kein Oxidationsmittel sondern H₂CO₃, oder H₃PO₄ oder H₄SiO₄ oder eine hochkonzentrierte Salzlösung der Anionen CO₃²⁻, PO₄³⁻ oder SiO₄⁴⁻ zuzuführen. Hierdurch erscheint es möglich, die Anionkerne auch ohne den Umweg über die Lithiumhalogensalze zu erhalten. Ein eventuell entstehendes Kondensat kann durch Entzug des entsprechenden Lösungsmittels entfernt werden und ein Festkörper zur Polarisationsübertragung auf die Anionkerne genutzt werden.

Nach diesen Ausführungen kann der Gesamtprozess anstatt in einer reinen Gasphase zumindest teilweise in einer Flüssigphase ablaufen.

### Bezugszeichenliste zu Fig. 6

- 1: He-Reservoir
- 2: Ventil
- 3: ⁴He-Gasstrom
- 4: Rb-Reservoir (T~200°C)
- 5: Rb-⁴He-Crasstrom
- 6: Li-Reservoir (T~900°C)
- 7: Li-Rb-⁴He-Gasstrom
- 8: zirkular polarisierter Laser (795 nm Rb D1 Linie)
- 9: Injektion von Wasserdampf
- 10: Kühlfalle
- 11: Al₂O₃ beschichtetes Quarzrohr (Saphir?
- 12: Kondensat Li⁺, Rb⁺, H₂O, OH⁻
- 13: Abgas ⁴He, H₂
- 14: Magnetfeld

### Bezugszeichenliste zu Fig. 7

- 1: Saphirrohr oder saphirbeschichtes Quarzrohr
- 2: Freistrahl ⁴He, N₂, Rb, Li
- 3: Zirkularpolansierter Laser mit Licht der D₁- Linie von Rb
- 4: Vorratsbehälter mit dem gasförmigen Oxidationsmittel (z.B. ⁴He, Cl₂) oder einem flüssigen Oxidationsmittel (z.B. H₂O)
- 5: Poröse Wand zur Einbringung des Oxidationsmittels
- 6: Reaktionszone
- 7: Gas und Reaktionsprodukte z.B. ⁴He, N₂, RbCl, LiCl, Cl₂
- 8: Abgeschiedene feste Reaktionsprodukte z.B. RbCl, LiCl
- 9: Abgas z.B. ⁴He, N₂, Cl₂
- 10: Kühlwasser ein
- 11: Kühlwasser aus
- 12: Ventil
- 13: Kältemittel z.B. füssiger N₂
- 14: Hallbachmagnet ~ 0.4 T

## Patentansprüche

1. Verfahren zur Hyperpolarisation von Lithiumatomen in einem Gasgemisch durch optisches Pumpen von Atomen einer ersten Alkalimetallsorte und Spinaustausch vom optisch gepumpten Elektron dieses Alkalimetalls auf das Elektron und den Kern eines Lithiumatoms in der Gasphase einer Probenzelle,
**gekennzeichnet durch**
Oxidation der Lithiumatome zu kernspingolarisierten Li⁺-Ionen **durch** Zugabe eines Oxidationsmittels wobei nach Wahl des Oxidationsmittels das entsprechende Lithiumsalz akkumuliert wird.

2. Verfahren nach einem der vorhergehenden Ansprüche,
**dadurch gekennzeichnet,**
**dass** die Kernspinpolarisation der Li⁺-Ionen auf einen Kernspin eines Anions übertragen wird.

3. Verfahren nach einem der vorhergehenden Ansprüche,
**gekennzeichnet durch**
optisches Pumpen mittels Laserlicht.

4. Verfahren nach einem der vorhergehenden Ansprüche,
**dadurch gekennzeichnet,**
**dass** das Gasgemisch neben der ersten Alkalimetallsone und Lithium, N₂ und ⁴He umfasst.

5. Verfahren nach einem der vorhergehenden Ansprüche,
**dadurch gekennzeichnet,**
**dass** das Gasgemisch ³He umfasst, wobei der Kernspin des ³He-Gases über die indirekt optisch gepumpten Li-Atome polarisiert wird.

6. verfahren nach einem der vorhergehenden Anspruche,
**gekennzeichnet durch**
Wahl von Rb-, Cs- oder K-Atomen als erste Alkalimetallsorte.

7. Verfahren nach einem der vorhergehenden Ansprüche,
**gekennzeichnet durch**
eine Dichte der ersten Alkalimetallsorte von 10¹¹ cm⁻³ bis 10¹⁵ cm⁻³ in der Probenzelle.

8. Verfahren nach einem der vorhergehenden Ansprüche,
**gekennzeichnet durch**
eine Dichte von Lithiumatomen von 10¹⁴ cm⁻³ bis 10¹⁸ cm⁻³ in der Probenzelle.

9. Verfahren nach einem der vorhergehenden Ansprüche,
**gekennzeichnet durch**
Hyperpolarisation von ⁶Li- oder ⁷Li-Atomen.

10. Verfahren nach einem der vorhergehenden Ansprüche,
**gekennzeichnet durch**
eine Temperatur von > 500 °C, insbesondere 900 bis 1200°C in der Probenzelle.

11. Verfahren nach einem der vorhergehenden Ansprüche,
**gekennzeichnet durch**
Oxidation des hyperpolarisierten Lithiumatoms mittels Cl₂, J₂, Br₂, D₂, H₂, H₂O, D₂O oder einem organischen Oxidationsmittel zum entsprechenden Lithiummolekül, bzw. -salz.

12. Verfahren nach Anspruch 11,
**dadurch gekennzeichnet,**
**dass** die hyperpolarisierten Lithiummoleküle als Festkörper abgeschieden oder in einem Lösungsmittel gelöst werden.

13. Verfahren nach Anspruch 12,
**dadurch gekennzeichnet,**
**dass** die Abscheidung in einem Magnetfeld größer 0,05 T erfolgt.

14. Verfahren nach einem der vorhergehenden Ansprüche,
**gekennzeichnet durch**
Akkumulation von bis zu 5-10²⁰ oder mehr hyperpolarisierter Li⁺-Ionen.

15. Verfahren nach einem der vorhergehenden Ansprüche 2 bis 14,
**dadurch gekennzeichnet,**
**dass** das Anion ¹³C, ²⁹Si, ³¹P oder einen anderen Kern mit einer Tj-Relaxationszeit 1 min umfasst.

16. Verfahren nach einem der vorhergehenden Ansprüche 2 bis 15,
**gekennzeichnet durch**
Wahl von CO₃²⁻, SiO₄⁴⁻ oder PO₄³⁻ als Anion.

17. Verfahren nach einem der vorhergehenden Ansprüche 2 bis 16,
**dadurch gekennzeichnet,**
**dass** die hyperpolarisierten Li⁺-Ionen und die Anionen in ein Lösungsmittel eingebracht werden.

18. Verfahren nach Anspruch 17,
**dadurch gekennzeichnet,**
**dass** die im Lösungsmittel befindlichen Li⁺-Ionen und/oder die Anionen ausgefällt werden.

19. Verfahren nach Anspruch 18,
**gekennzeichnet durch**
Ausfällung eines Festkörpers **durch** Verdampfen des Lösungsmittels.

20. Verfahren nach einem der vorhergehenden Ansprüche,
**gekennzeichnet durch**
eine Kreuzpolarisation oder ein Fieldcyclingverfahren.

21. Verfahren nach Anspruch 19,
**dadurch gekennzeichnet,**
**dass** die Kernspinpolarisation der Li⁺-Ionen im Festkörper auf Kerne des Anions im Festkörper übertragen wird.

22. Vorrichtung zur Durchführung eines Verfahrens nach einem der vorhergehenden Patentansprüche mit einer Probenzelle,
**gekennzeichnet durch**
Wahl von Saphir oder mit Saphir beschichtetem Quarzglas als Innenwandmaterial der Probenzelle.

23. Vorrichtung nach Anspruch 22,
**gekennzeichnet durch**
mindestens zwei Heizsysteme, eines für Lithium und das andere für das erste Alkalimetall.

## Claims

1. Method for hyperpolarisation of lithium atoms in a gas mixture through optical pumping of atoms of a first type of alkali metal and spin exchange of the optically pumped electron of this alkali metal on the electron and the nucleus of a lithium atom in the gas phase of a sampling cell,
**characterised by**
oxidation of the lithium atoms to nuclear spin polarised Li⁺ ions by adding an oxidising agent, in which the relevant lithium salt is accumulated according to the selection of the oxidising agent.

2. Method according to one of the previous claims,
**characterised in that**
the nuclear spin polarisation of Li⁺ ions is transferred to a nuclear spin of an anion.

3. Method according to one of previous claims,
**characterised by**
optical pumping by means of laser light.

4. Method according to one of the previous claims,
**characterised in that**
the gas mixture comprises N₂ and ⁴He as well as the first type of alkali metal and lithium.

5. Method according to one of the previous claims,
**characterised in that**
the gas mixture comprises ³He, in which the nuclear spin of the ³He gas is polarised through the indirectly optically pumped Li atoms.

6. Method according to one of the previous claims,
**characterised by**
the selection of Rb, Cs or K atoms as the first type of alkali metal.

7. Method according to one of the previous claims,
**characterised by**
the first type of alkali metal having a density of 10¹¹ cm⁻³ to 10¹⁵ cm⁻³ in the sampling cell.

8. Method according to one of the previous claims,
**characterised by**
the lithium atoms having a density of 10¹⁴ cm⁻³ to 10¹⁵ cm⁻³ in the sampling cell.

9. Method according to one of the previous claims,
**characterised by**
hyperpolarisation of ⁶Li or ⁷Li atoms.

10. Method according to one of the previous claims,
**characterised by**
a temperature of > 500° C, particularly 900 to 1200° C, in the sampling cell.

11. Method according to one of the previous claims,
**characterised by**
oxidation of the hyperpolarised lithium atom by means of Cl₂, J₂, Br₂, D₂, H₂, H₂O, D₂O or an organic oxidising agent to the relevant lithium molecule or salt.

12. Method according to claim 11,
**characterised in that**
the hyperpolarised lithium molecules are separated out as solid bodies or dissolved in a solvent.

13. Method according to claim 12,
**characterised in that**
separation is carried out in a magnetic field greater than 0.05 T.

14. Method according to one of the previous claims,
**characterised by**
the accumulation of up to 5 10²⁰ or more hyperpolarised Li⁺ ions.

15. Method according to one of the previous claims 2 to 14,
**characterised in that**
the anion comprises ¹³C, ²⁹Si, ³¹P or another nucleus with a T₁ relaxation time > 1 min.

16. Method according to one of the previous claims 2 to 15,
**characterised by**
the selection of CO₃²⁻, SiO₄⁴⁻ or PO₄³⁻ as anion.

17. Method according to one of the previous claims 2 to 16,
**characterised in that**
the hyperpolarised Li⁺ ions and the anions are put into a solvent.

18. Method according to claim 17,
**characterised in that**
the Li⁺ ions in the solvent and/or the anions are precipitated.

19. Method according to claim 18
**characterised by**
precipitation of a solid body through evaporation of the solvent.

20. Method according to one of the previous claims,
**characterised by**
a cross polarisation or a field cycling method.

21. Method according to claim 19,
**characterised in that**
the nuclear spin polarisation of the Li⁺ ions in the solid body is transferred to the nuclei of the anion in the solid body.

22. Device for carrying out a method according to one of the previous patent claims with a sampling cell,
**characterised by**
the selection of sapphire or quartz glass coated with sapphire as the inner wall material of the sampling cell.

23. Device according to claim 22,
**characterised by**
at least two heating systems, one for lithium and the other for the first alkali metal.

## Revendications

1. Procédé d'hyperpolarisation d'atomes de lithium dans un mélange gazeux par pompage optique d'atomes d'une première sorte de métaux alcalins et échange de spin de l'électron pompé optiquement de ce métal alcalin sur l'électron et le noyau d'un atome de lithium dans la phase gazeuse d'une cellule d'échantillon,
**caractérisé par**
l'oxydation de l'atome de lithium en ions Li⁺ par polarisation nucléaire par addition d'un agent oxydant, le sel de lithium correspondant étant accumulé selon le choix de l'agent oxydant.

2. Procédé selon l'une des revendications précédentes,
**caractérisé en ce**
**que** la polarisation nucléaire des ions Li⁺ est transmise à un spin nucléaire d'un anion.

3. Procédé selon l'une des revendications précédentes,
**caractérisé par**
un pompage optique au moyen d'une lumière laser.

4. Procédé selon l'une des revendications précédentes,
**caractérisé en ce**
**que** le mélange gazeux comprend, outre la première sorte de métaux alcalins et le lithium, du N₂ et du ⁴He.

5. Procédé selon l'une des revendications précédentes,
**caractérisé en ce**
**que** le mélange gazeux comprend du ³He, le spin nucléaire du gaz de ³He étant polarisé par les atomes de Li pompés optiquement de façon indirecte.

6. Procédé selon l'une des revendications précédentes,
**caractérisé par**
le choix d'atomes de Rb, Cs ou K comme première sorte de métaux alcalins.

7. Procédé selon l'une des revendications précédentes,
**caractérisé par**
une densité de la première sorte de métaux alcalins de 10¹¹ cm⁻³ à 10¹⁵ cm⁻³ dans la cellule d'échantillon.

8. Procédé selon l'une des revendications précédentes,
**caractérisé par**
une densité d'atomes de lithium de 10¹⁴ cm⁻³ à ₁₀¹⁸ cm⁻³ dans la cellule d'échantillon.

9. Procédé selon l'une des revendications précédentes,
**caractérisé par**
une hyperpolarisation des atomes de ⁶Li ou ⁷Li .

10. Procédé selon l'une des revendications précédentes,
**caractérisé par**
une température > 500° C, notamment de 900 à 1200° C dans la cellule d'échantillon.

11. Procédé selon l'une des revendications précédentes,
**caractérisé par**
l'oxydation de l'atome de lithium hyperpolarisé au moyen de Cl₂, J₂, Br₂, D₂, H₂, H₂O, D₂O ou d'un agent oxydant organique en une molécule ou un sel de lithium correspondant(e).

12. Procédé selon la revendication 11,
**caractérisé en ce**
**que** la molécule de lithium hyperpolarisée est séparée en tant que corps solide ou est dissoute dans un solvant.

13. Procédé selon la revendication 12,
**caractérisé en ce**
**que** la séparation s'effectue dans un champ magnétique supérieur à 0,05 T.

14. Procédé selon l'une des revendications précédentes,
**caractérisé par**
une accumulation allant jusqu'à 5. 10²⁰ ou plus d'ions Li⁺ hyperpolarisés.

15. Procédé selon l'une des revendications 2 à 14,
**caractérisé en ce**
**que** l'anion comprend les ¹³C, ²⁹Si, ³¹P ou un autre noyau présentant un temps de relaxation T₁ supérieur à 1 minute.

16. Procédé selon l'une des revendications 2 à 15,
**caractérisé par**
le choix de CO₃ ²⁻, SiO₄⁴⁻ ou PO₄³⁻ comme anion.

17. Procédé selon l'une des revendications 2 à 16,
**caractérisé en ce**
**que** les ions Li⁺ hyperpolarisés et les anions sont incorporés dans un solvant.

18. Procédé selon la revendication 17,
**caractérisé en ce**
**que** les ions Li⁺ et/ou les anions se trouvant dans le solvant sont précipités.

19. Procédé selon la revendication 18,
**caractérisé par**
la précipitation d'un corps solide par évaporation du solvant.

20. Procédé selon l'une des revendications précédentes,
**caractérisé par**
une polarisation croisée ou un procédé de cyclage de champ.

21. Procédé selon la revendication 19,
**caractérisé en ce**
**que** la polarisation nucléaire des ions Li⁺ dans le corps solide est transmise aux noyaux de l'anion dans le corps solide.

22. Dispositif de réalisation d'un procédé selon l'une des revendications précédentes, comportant une cellule d'échantillon,
**caractérisé par**
le choix d'un saphir ou d'un verre de quartz revêtu de saphir comme matériau de paroi interne de la cellule d'échantillon.

23. Dispositif selon la revendication 22,
**caractérisé par**
au moins deux systèmes de chauffage, l'un pour le lithium et l'autre pour la première sorte de métaux alcalins.
